# EUROPEAN PATENT APPLICATION

(11) **EP 0 525 293 A1**
(43) Date of publication of application: **03.02.1993**
(21) Application number: 92104581.1
(22) Date of filing: 17.03.1992
(51) Int. Cl.: G03F 7/20

(54) **Mask holder in exposure device**

(30) Priority: 18.06.1991 JP 171815/91
(71) Applicant: Saiki, Minoru, Tokyo (JP)
(72) Inventor: Saiki, Minoru, Tokyo (JP)
(74) Representative: Leiser, Gottfried, Dipl.-Ing.

(57) **Abstract**

To enable a safe and positive holding of a mask and a substrate to be attained without damaging the mask and the substrate, facilitate a fitting or a removal of the flat plate holder or the mask dry plate and to enable an easy and positive holding of the mask dry plate to the frame without working any holes or grooves in the mask dry plate and without damaging the mask.

A elastic magnetic packing is adsorbed to a lower surface of the metallic frame which can be moved up or down, the packing is formed with an upper suction hole and a lower suction hole, the flat plate holder is adsorbed against the lower surface of the packing, the mask holder is adsorbed under vacuum in the upper suction groove formed in the holder and then the pattern film or the pattern glass dry plate is closely contacted under vacuum in the lower suction groove formed in the holder.

## Description

### Detailed Description of the Invention

### Industrial Field of the Invention

This invention relates to a mask holder device in exposure device for printing a photo-ethcing pattern to one surface or both surfaces in a high precision when an IC lead frame, a printed circuit board, a semiconductor element or other electronic parts or various precision parts are formed.

### Description of the Prior Art

As an exposure device in a prior art photo- etching, a mask and a substrate are closely contacted after masking alignment and a close contacting process in the event of performing an exposure, a hard contact process is present. This process is carried out such that the mask is closely contacted by a mechanical force, i.e. compressed gas or vacuum (atmospheric pressure).

As the prior art mask holder device, a fixing fitting or the like was fixed to a circumference of a glass plate and the fixing fitting or the like was fixed to the frame through bolts and nuts. Or, an adhesive was spread to a circumference of the glass plate or a double-sided tape was adhered to it to fix the glass plate to the frame. A pattern film was fitted to the fixed glass plate.

### Problem to be Resolved by the Invention

The mask holder device of the prior art was troublesome in the event of fixing or removing the glass plate when the glass plate was fixed to the frame through the fixing fitting and bolts and nuts and in turn in the event that the glass plate itself was used as a mask dry plate, a punching a hole in the glass plate or forming a groove in its caused a damage to the mask pattern or difficult in view of the reasons of keeping a confidential information.

In the event that the glass plate was fixed to the frame by adhesive or bi-surface adhering tape, it took much time to perform a replacing work of the glass plate or its maintenance work or the like.

The present invention has been invented in view of the above points, and its object is to provide a mask holder device in exposure device in which the mask and the substrate can be held safely and positively without damaging them, the flat plate holder made of transparent material or the mask dry plate formed by transparent material can be easily fixed or removed and also when the glass plate itself was used as the mask dry plate, it is not necessary to make a punched hole in the glass plate or working the groove or the like and further the mask plate can be easily and positively held at the frame without making any damage to the mask and it can be adapted to one surface exposure or bilateral exposure for the substrate formed with a resist.

### Summary of the Invention

The mask holder device in an exposure device of the present invention is constructed such that a photo-mask is closely contacted with either a substrate or a thin film formed with a resist and a light beam is irradiated to perform an exposure and in which an elastic magnetic packing is adsorbed against a lower surface of a metallic frame which can be moved up and down, said elastic magnetic packing is formed with an upper suction hole and a lower suction hole, a flat plate holder made of transparent material is removably attached below the elastic magnetic packing in a horizontal direction, a peripheral edge of an upper surface of the said flat plate holder is formed with an upper suction groove communicating with said upper suction hole, the flat plate holder is closely contacted and supported in a horizontal direction with vacuum within the said upper suction groove covered by the elastic magnetic packing, a peripheral edge of a lower surface of the flat plate holder is formed with a lower suction groove communicating with the said lower suction hole, and either a pattern film or a pattern glass dry plate is closely contacted with a lower surface of the flat plate holder with vacuum in the lower suction groove.

The flat plate holder made of transparent material is formed by a glass plate or a plastic plate.

The elastic magnetic packing is a plate-like packing formed by a magnetic rubber or resin.

The mask holder device in a bilateral exposure device of the present invention is constructed such that a photo-mask is closely contacted with each of both surfaces of a substrate or a thin film having a resist formed therein and light is irradiated from above and below the surfaces to perform an exposure and that an upper elastic magnetic packing is adsorbed against a lower surface of a metallic upper frame which can be moved up and down, said upper elastic magnetic packing is formed with an upper suction hole and a lower suction hole, an upper flat plate holder made of transparent material is removably attached in a horizontal direction below said elastic magnetic packing, an upper surface peripheral edge of said upper flat plate holder is formed with an upper suction groove communicating with said upper suction hole, the upper flat plate holder is closely fitted or supported in a horizontal direction at a lower surface of the upper elastic magnetic packing with vacuum in said upper suction groove covered by the upper elastic magnetic packing, the lower suction groove communicating with said lower suction hole is formed at the lower surface peripheral edge of the upper flat plate holder, either an upper pattern film or an upper pattern glass dry plate adsorbed with vacuum in the upper suction groove is arranged at the lower surface of the upper flat plate holder, the lower elastic magnetic packing is adsorbed at the upper surface of the metallic lower frame, said lower elastic magnetic packing is formed with an upper suction hole and a lower suction hole, a lower flat plate holder made of transparent material is mounted on the upper surface of the lower elastic magnetic packing, a peripheral edge of the lower surface of said lower flat plate holder is formed with a lower suction groove communicating with said lower suction hole and the lower flat plate holder is closely contacted and supported in a horizontal direction with vacuum within said lower suction groove covered by the lower elastic magnetic packing, a peripheral edge of an upper surface of the lower flat plate holder is formed with an upper suction groove communicating with said upper suction hole, and either the lower pattern film or a lower pattern glass dry plate adsorbed with vacuum within the upper suction groove is arranged on the upper surface of the lower flat plate holder.

The flat plate holders over and below the flat plate made of transparent material are formed of glass plate or plastic plate.

The upper elastic magnetic packing and the lower elastic magnetic packing are plate-like packings made of magnetic rubber or resin.

The mask holder device in exposure device of the present invention is constructed such that a photo-mask is closely contacted with a substrate or a thin film formed with a resist and a light beam is irradiated to expose it and that an upper elastic packing formed with a suction longitudinal hole is installed in a groove or a projection formed at a lower surface of the metallic upper frame which can be moved up or down, and the upper glass mask dry plate is closely contacted to and supported in a horizontal direction by vacuum in said suction longitudinal hole.

In the mask holder in the exposure device, the upper elastic packing is a plate-like packing made of magnetic rubber or resin.

A mask holder device in a bilateral exposure device is made such that a photo-mask is closely contacted with each of both surfaces of a substrate or a thin film formed with a resist and a light beam is irradiated from above and below to expose the films and that an upper elastic packing formed with a suction longitudinal hole is installed in a groove or a projection formed at the lower surface of the metallic frame which can be moved up or down, the upper glass mask dry plate is closely contacted to and supported at the lower surface of the upper elastic packing with vacuum in said suction longitudinal hole and in turn the lower elastic packing formed with a suction longitudinal hole is installed in a groove or a projection formed on the upper surface of the metallic lower frame, the lower glass mask dry plate formed of transparent material is mounted in a horizontal direction on the upper surface of the lower elastic packing, and a peripheral edge of the lower surface of the lower glass mask dry plate is closely contacted by vacuum in the suction longitudinal hole formed in said lower elastic packing.

In the mask holder device in a bilateral exposure device, the upper elastic packing and the lower elastic packing are plate-like packings made of magnetic rubber or resin.

### Action

A method for using the mask holder device in the exposure device of the present invention is described as follows.

A elastic magnetic packing is adsorbed through utilization of a magnetic force of the magnet at the lower surface of a metallic frame which can be moved up or down. An upper suction groove of the flat plate holder formed by transparent material communicating with the upper suction hole formed at the elastic magnetic packing is made into vacuum by a vacuum pump and the flat plate holder is closely contacted to the lower surface of the elastic magnetic packing. At the lower surface of the flat plate holder, the lower suction groove communicating with the lower suction hole of the elastic magnetic packing is made into vacuum by a vacuum pump or the like and then either a pattern film or a pattern glass dry plate is closely contacted to it. In this way, after either the pattern film or the pattern glass dry plate is closely contacted with the lower surface of the flat plate holder, either a substrate or the thin film having resist formed thereon is relatively aligned in position to the rear surface of the pattern film or the pattern glass dry plate, fixed and then exposed.

Then, the mask holder device in which either the pattern film or the pattern glass dry plate of the mask holder device in a bilateral exposure device is used will be described.

The elastic magnetic packing is adsorbed through utilization of an magnetic force of the magnet to the lower surface of the metallic frame which can be move up or down. Upper suction groove of the flat plate holder formed by transparent material communicating with the upper suction hole formed at the elastic magnetic packing is made into vacuum by a vacuum pump or the like and then the flat plate holder is closely contacted with the lower surface of the elastic magnetic packing. The lower suction groove of the flat plate holder communicating with the lower suction hole of the elastic magnetic packing is made into vacuum by a vacuum pump or the like and then either the pattern film or the pattern glass dry plate is closely contacted the lower surface of the flat plate holder.

In turn, the lower elastic magnetic packing is adsorbed through a utilization of an magnetic force of the magnet to the upper surface of the metallic lower frame. The lower suction groove of the flat plate holder formed by transparent material communicating with the lower suction hole formed at the elastic magnetic packing is made into vacuum by a vacuum pump or the like and then the flat plate holder is closely contacted to the upper surface of the elastic magnetic packing.

An upper suction groove communicating with an upper suction hole of an elastic magnetic packing is changed into a vacuum state by a vacuum pump or the like and a pattern film or a pattern glass dry plate is closely contacted with an upper surface of the flat plate holder. Either a substrate or a thin film formed with a resist is relatively positioned, relatively aligned and held between the upper flat plate holder and the lower flat plate holder. Thus, both front and rear surfaces of either the substrate or the thin film are exposed.

Then, the mask holding device in the event that the glass mask dry plate of the mask holder device in the exposure device will be described.

An upper elastic magnetic packing formed with a suction longitudinal hole is installed in the groove or projection formed on the lower surface of the metallic upper frame which can be moved up or down. In the event that the upper elastic packing is made of magnetic rubber or resin, it is easily installed under a utilization of the magnetic force of the magnet and then a maintenance work such as a repairing or a replacing can be easily carried out. The suction longitudinal hole formed in the upper elastic packing is made into vacuum state by a vacuum pump or the like and then the upper glass mask dry plate is closely contacted and supported in a horizontal direction at the lower surface of the upper elastic packing.

In this way, the substrate or the thin film having a resist formed on it is relatively aligned in its position with the rear surface of the upper glass mask dry plate, fixed there to perform an exposing operation.

The mask holding device in which the glass mask dry plate of the mask holder device in the bilateral exposure device will be described.

The upper elastic packing formed with a suction longitudinal hole is installed in a groove or a projection formed at the lower surface of the metallic upper frame which can be moved up or down. In the event that the upper elastic packing is made of magnetic rubber or resin, it can easily be installed under a utilization of a magnetic force of the magnet. The suction longitudinal hole formed in the upper elastic packing is made into a vacuum state by a vacuum pump or the like, and then the upper glass mask dry plate is closely contacted to and supported to the lower surface of the upper elastic packing. In its turn, the lower elastic packing formed with a suction longitudinal hole is installed in a groove or a projection formed in the metallic lower frame. In the event that the lower elastic packing is made of magnetic rubber or resin, it can be easily and positively installed under a utilization of a magnetic force of the magnet. The suction longitudinal hole formed in the lower elastic packing is made into a vacuum state by a vacuum pump or the like, and the lower glass mask dry plate made of transparent material is closely contacted and supported in a horizontal direction on the upper surface of the lower elastic packing.

In this way, the substrate or the thin film formed with a resist on the both surfaces is relatively set in its position between the upper glass mask dry plate and the lower glass mask dry plate, held between them to expose the front and rear surfaces of the substrate or the thin film and to get a desired pattern.

### Preferred Embodiment

One preferred embodiment of the present invention will be described in reference to the drawings.

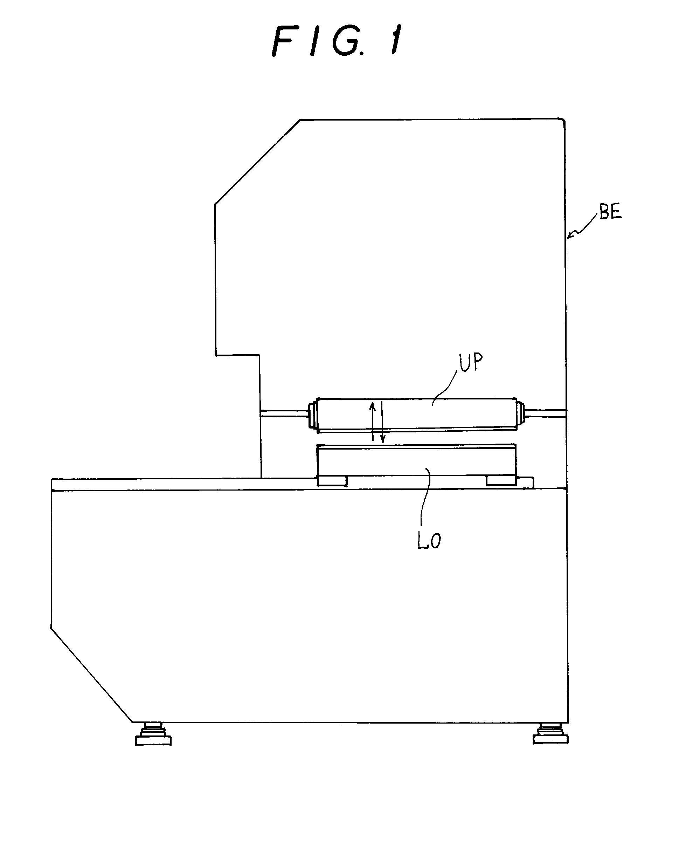

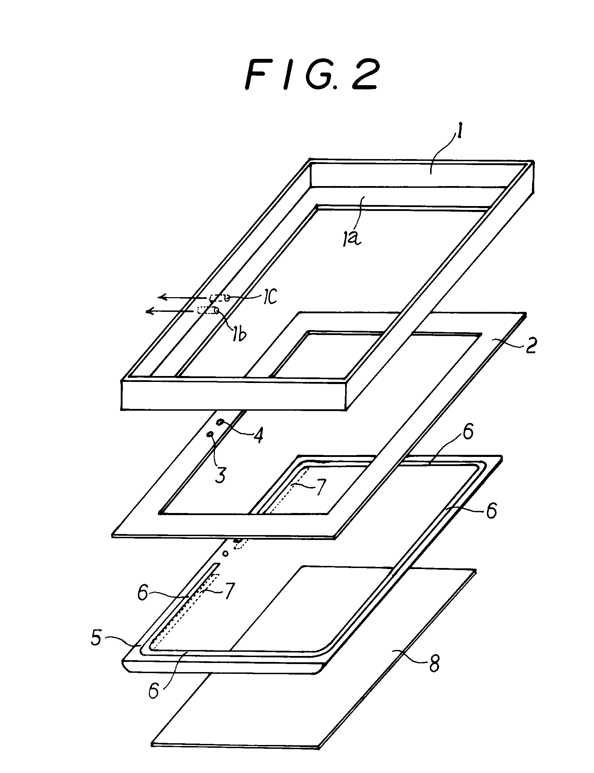

Fig. 1 is a schematic view for showing a bilateral surface exposure device BE of the present invention, in which the device BE is provided with an upper mask holder UP and a lower mask holder LO. Fig. 2 is a perspective view for showing a mask holder device in the exposure device of the present invention.

1 denotes a metallic upper frame which can be moved up or down, in which the frame has a rectangular shape in its top plan view and it forms a belt-like extension piece 1 a extending from a circumference of the lower surface inwardly in a horizontal direction. At the predetermined locations of the extension piece 1 a are provided each of holes 1 and 1 at the positions corresponding to the upper suction hole 3 and the lower suction hole 4 formed in the elastic magnetic packing 2 to be described rater and they are connected to a vacuum pump (not shown).

The elastic magnetic packing 2 is formed into a plate-like shape corresponding to the extension piece 1 a of the upper frame 1 and it is adsorbed and fixed to the lower surface of the extension piece 1 a under a utilization of magnet. The elastic magnetic packing 2 is made of magnetic rubber or resin material.

5 denotes a flat plate holder formed by transparent material which is removably attached to the main body of the exposure device (not shown) in a horizontal direction through a supporting member (not shown) and it is located below the elastic magnetic packing 2. The flat plate holder 5 is supported on the supporting member (not shown) in such a way as it can be slightly varied in a vertical direction.

The flat plate holder 5 formed by transparent material is formed by a glass plate or a plastic plate.

At a peripheral edge of the upper surface of the flat plate holder 5 is formed the upper suction groove 6 communicating with the upper suction hole 3. The upper suction groove 6 covered by the elastic magnetic packing 2 is made into a vacuum state by a vacuum pump (not shown), thereby the flat plate holder 5 is closely contacted with or supported by the extension piece 1 a of the upper frame 1 through the elastic magnetic packing 2 in a horizontal direction. A lower circumferential edge of the flat plate holder 5 is formed with the lower suction groove 7 communicating with the lower suction hole 4. And then, at the lower surface of the flat plate holder 5 is closely contacted the desired pattern film 8 or the pattern glass dry plate (in the event that the pattern glass dry plate is used, it is preferable to employ the plate thinner than that of the flat plate holder 5) by setting the lower suction groove 7 into a vacuum state through a vacuum pump (not shown).

In this ways, after either the pattern film 8 or the pattern glass dry plate is closely contacted with the lower surface of the flat plate holder 5 below the extension piece 1 a, a resist 9a (including the case in which a photosensitive material is used) is formed at the rear surface of the pattern film 8 or the pattern glass dry plate, the substrate 9 or the thin film is relatively aligned in its position and fixed and then an exposure is carried out.

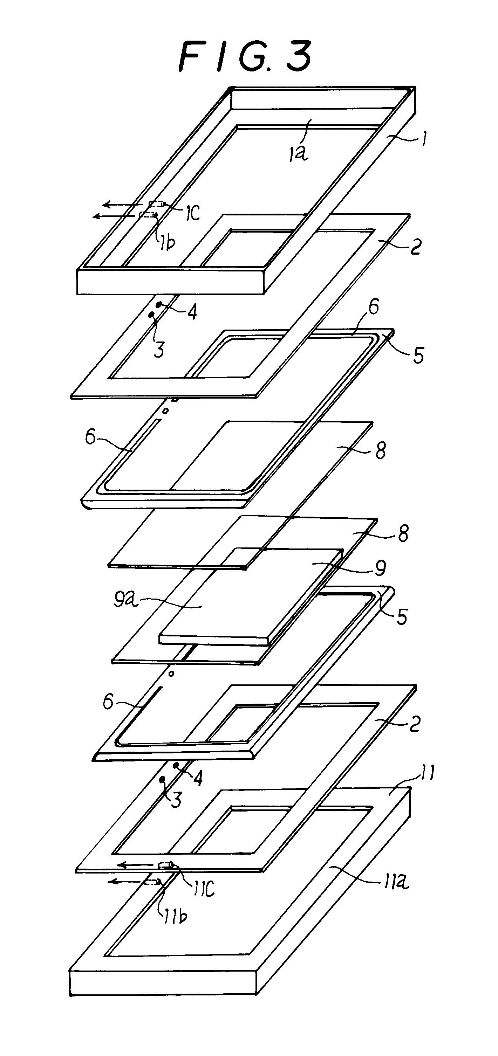

Fig. 3 is a perspective view for showing a mask holder device in the event that either the pattern film of the pattern glass dry plate of the mask holder device in the bilateral exposure device is used.

The upper mask holder device had the same structure as that of the preferred embodiment shown in Fig. 2, wherein the upper frame 1 provided with the extension piece 1 a, the elastic magnetic packing 2 provided with an upper suction hole 3 and a lower suction hole 4, a flat plate holder 5 provided with an upper suction groove 6 and a lower suction groove 7, and the pattern film or the pattern glass dry plate 8 are similarly arranged.

The lower mask holder device is basically the same as the upper mask holder device in view of its structure and it has a symmetrical structure in its vertical direction. That is, the metallic lower frame 11 has a rectangular shape in its top plan view and a belt-like extension piece 11 a extending in a horizontal direction from its circumference of the upper surface inwardly is formed. At the predetermined locations in the extension piece 11 a are formed the holes 11 and 11 at the positions corresponding to the upper suction hole 3 and the lower suction hole 4 formed at the lower elastic magnetic packing 2, respectively, and the holes are connected to the vacuum pump (not shown).

The lower elastic magnetic packing 2 is formed into a plate-like shape corresponding to the extension piece 11 a of the lower frame 11, and it is adsorbed and fixed to the upper surface of the extension piece 11 a under a utilization of magnet.

A circumferential edge of the lower surface of the lower flat plate holder 5 is formed with a lower suction groove 7 communicating with the lower suction hole 4. The lower suction groove 7 is made into a vacuum state through a vacuum pump (not shown), thereby the lower flat plate holder 5 is closely contacted and supported in a horizontal direction to the extension piece 11 a of the lower frame 11 through the elastic magnetic packing 2. A circumferential edge of the upper surface of the lower flat plate holder 5 is formed with the upper suction groove 6 communicating with the upper suction hole 3. On the upper surface of the lower flat plate holder 5 is closely contacted the desired upper pattern film 8 or the pattern glass dry plate by setting the upper suction groove 6 to a vacuum state through the vacuum pump (not shown).

After the lower pattern film 8 or the pattern glass dry plate is closely contacted with the upper surface of the lower flat plate holder 5 facing the extension piece 11 a, either the substrate 9 or the thin film having a resists 9a formed at its front and rear surfaces is relatively aligned in its position between the upper pattern film 8 or the pattern glass dry plate and the lower pattern film 8 or the pattern glass dry plate, held there and fixed to perform an exposure.

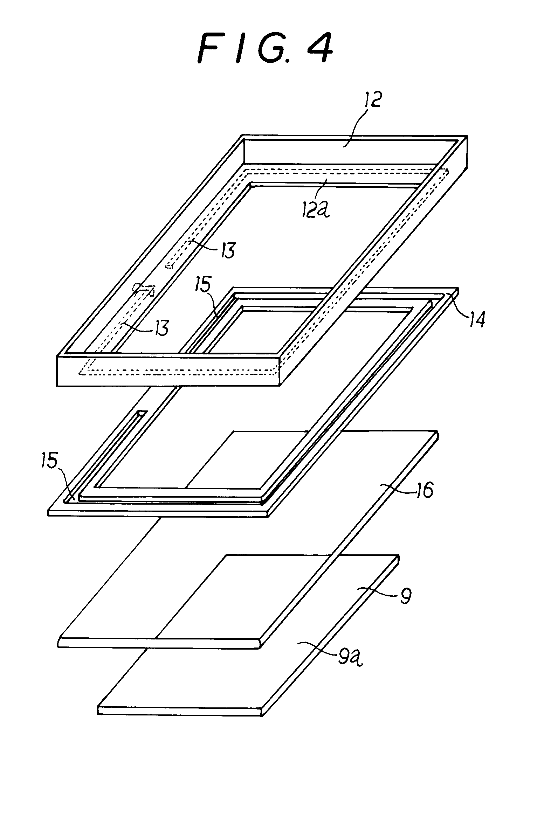

Fig. 4 is a perspective view for showing a mask holder device in which the glass mask dry plate of the mask holder device in the exposure device is used.

The metallic upper frame 12 which can be moved up or down has a rectangular shape in section and forms a belt-like extension piece 12a extending from a circumferential part of the lower surface inwardly in a horizontal direction. Either the groove or projection 13 is formed along the lower surface of the extension piece 12a. The upper elastic packing 14 formed with the suction longitudinal hole 15 is installed at the groove or the projection 13. The upper elastic packing 14 is of a plate-like packing made of magnetic rubber or resin and it is not necessary to fix it with the adhesive and thus a replacing work or the like is facilitated.

The upper elastic packing 14 is formed with the suction longitudinal hole 15 acting as a spacing for evacuating air the air passage at its central part. This suction longitudinal hole 15 is connected to the vacuum pump (not shown).

16 denotes the upper glass mask dry plate positioned below the upper elastic packing 14. The upper glass mask dry plate 16 can be closely fitted and supported in a horizontal direction with vacuum in the suction longitudinal hole 15.

In this way, the upper glass mask dry plate 16 and either the substrate 9 or the thin film formed with the resist 9a are relatively aligned in their positions, thereafter an exposure is carried out to get a desired pattern.

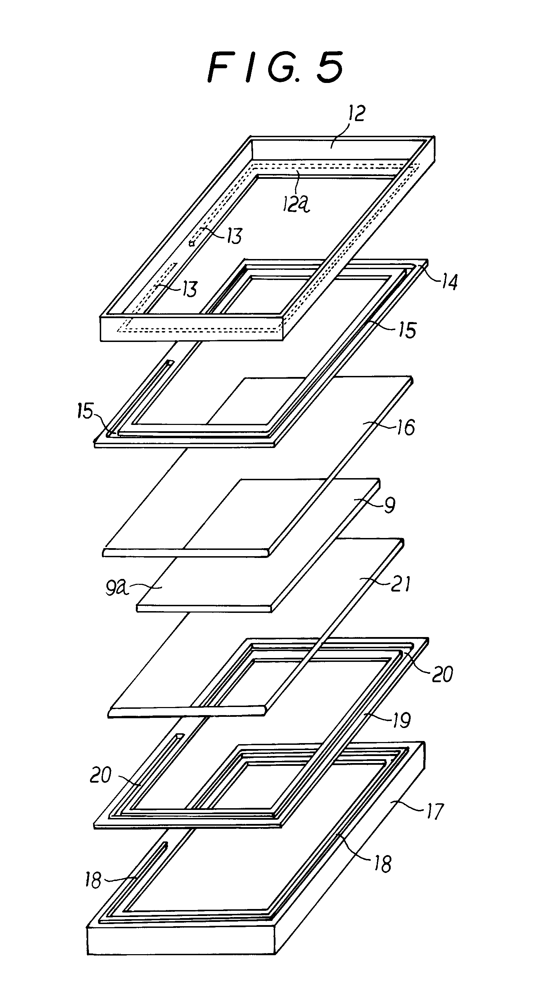

Fig. 5 is a perspective view fir showing a mask holder device in which the glass mask dry plate of the mask holder device in the bilateral exposure device.

The metallic upper frame 12 which can be moved up or down has a rectangular shape in its top plan view and a belt-like extension piece 12a extending horizontally from the peripheral part of the lower surface inwardly is formed. The groove or the projection 13 is formed along the lower surface of the extension piece 12a. The upper elastic packing 14 formed with the suction longitudinal hole 15 is installed in the groove or the projection 13. The upper elastic packing 14 is of a plate-like packing made of magnetic rubber or resin, thereby it is not necessary to fix it with adhesive and its replacement work or the like is facilitated.

The upper elastic packing 14 is formed with the suction longitudinal hole 15 acting as a spacing for evacuating vacuum air at its central part. This suction longitudinal hole 15 is connected to the vacuum pump (not shown).

16 denotes the upper glass mask dry plate located below the upper elastic packing 14.

The upper glass mask dry plate 16 can be closely fitted and supported under vacuum in the suction longitudinal hole 15.

In its turn, the metallic lower frame 17 similar to the upper frame 12 has a rectangular shape in its top plan view so as to form a belt-like extension piece 17a projecting in a horizontal direction from a peripheral part of the upper part inwardly. The lower elastic packing 19 formed with the suction longitudinal hole 20 is installed in a groove or a projection 13 formed on the upper surface of the extension piece 17a. The lower circumferential edge of the lower glass mask dry plate 21 is closely contacted with the upper part of the lower elastic packing 19 in the same manner as that of the upper glass mask dry plate 16 under vacuum in the suction longitudinalhole 20 formed in the lower elastic packing 19.

Either the substrate 9 or the thin film formed with a resist 9a on the both surfaces is relatively aligned in its position and held between the upper glass mask dry plate 16 and the lower glass mask dry plate 21. In this way, either the front and rear surfaces of the substrate 9 or the thin film is exposed to get a desired pattern.

### Effects of the Invention

As apparent from the above description, the present invention can perform a safe and positive holding of the mask and the substrate or thin film formed with a resist without damaging them. In addition, a fitting or a removal of the flat plate holder made of transparent material or the mask dry plate made of transparent material can be facilitated. In addition, even in the case that either the glass plate or the plastic plate itself is used as the mask dry plate, the glass plate or the plastic plate is not formed with anyholes or grooves and further the mask is not damaged, the plate can be applied to either one-surface exposure or bilateral exposure of the substrate or the thin film formed with a resist while being simply and positively held at the frame and thus a value of utilization of the present invention as the mask holder device in this type of exposure device.

### Brief Description of the Drawings

Fig. 1 is a schematic illustration for showing a bilateral exposure device of the present invention.
Fig. 2 is a perspective view for showing a mask holder device in an exposure device of the present invention.
Fig. 3 is a perspective view for showing a positional relation of the holder devices in the mask holder device in the bilateral exposure device in the case that either the pattern film or the pattern glass dry plate is used.
Fig. 4 is a perspective view for showing a holder device in the event that the glass mask dry plate of the mask holder device in the exposure device is used.
Fig. 5 is a perspective view for showing the holder device in the event that the glass mask dry plate of the mask holder device in the bilateral exposure device is used.

## Claims

1. In an exposure device in which a photo-mask is closely contacted with either a substrate or a thin film formed with a resist and a light beam is irradiated to perform an exposure, a mask holder characterized in that an elastic magnetic packing is adsorbed against a lower surface of a metallic frame which can be moved up and down, the said elastic magnetic packing is formed with an upper suction hole and a lower suction hole, a flat plate holder made of transparent material is removably attached below the elastic magnetic packing in a horizontal direction, a peripheral edge of an upper surface of the said flat plate holder is formed with an upper suction groove communicating with the said upper suction hole, the flat plate holder is closely contacted and supported in a horizontal direction with vacuum within the said upper suction groove covered by the elastic magnetic packing, a peripheral edge of a lower surface of the flat plate holder is formed with a lower suction groove communicating with the said lower suction hole, and either a pattern film or a pattern glass dry plate is closely contacted with a lower surface of the flat plate holder with vacuum in the lower suction groove.

2. A mask holder in exposure device according to Claim 1 in which the flat plate holder made of transparent material is formed of a glass plate or a plastic plate.

3. A mask holder in exposure device according to Claim 1 or Claim 2 in which the elastic magnetic packing is a plate-like packing made of magnetic rubber or resin.

4. In a bilateral exposure device in which a photo-mask is closely contacted with each of both surfaces of a substrate or a thin film having a resist formed thereon and a light is irradiated from above and below both surfaces to perform an exposure, a mask holder characterized in that an upper elastic magnetic packing is adsorbed against a lower surface of a metallic upper frame which can be moved up and down, the said upper elastic magnetic packing is formed with an upper suction hole and a lower suction hole, an upper flat plate holder made of transparent material is removably attached in a horizontal direction below the said elastic magnetic packing, a peripheral edge of an upper surface of the said upper flat plate holder is formed with an upper suction groove communicating with the said suction hole, the upper flat plate holder is closely contacted or supported in a horizontal direction at a lower surface of the upper elastic magnetic packing with vacuum in the said upper suction groove covered by the upper elastic magnetic packing, the lower suction groove communicating with the said lower suction hole is formed at the peripheral edge of the lower surface of the upper flat plate holder, either an upper pattern film or an upper pattern glass dry plate adsorbed with vacuum in the upper suction groove is arranged at the lower surface of the upper flat plate holder, the lower elastic magnetic packing is adsorbed at the upper surface of the metallic lower frame, the said lower elastic magnetic packing is formed with an upper suction hole and a lower suction hole, a lower flat plate holder made of transparent material is mounted on the upper surface of the lower elastic magnetic packing, a peripheral edge of the lower surface of the said lower flat plate holder is formed with a lower suction groove communicating with the said lower suction hole and the lower flat plate holder is closely contacted and supported in a horizontal direction with vacuum within the said lower suction groove covered by the lower elastic magnetic packing, a peripheral edge of an upper surface of the lower flat plate holder is formed with an upper suction groove communicating with said upper suction hole, and either the lower pattern film or a lower pattern glass dry plate adsorbed with vacuum within the upper suction groove is arranged on the upper surface of the lower flat plate holder.

5. A mask holder device in the bilateral exposure device according to Claim 4 characterized in that the flat plate holders over and below the flat plate made of transparent material are formed of glass plate or plastic plate.

6. A mask holder device in the bilateral exposure device according to Claim 4 or 5 characterized in that the upper elastic magnetic packing and the lower elastic magnetic packing are plate-like packings made of magnetic rubber or resin.

7. In the exposure device in which a photo-mask is closely contacted with a substrate or a thin film formed with a resist and a light beam is irradiated to expose it, a mask holder device characterized in that an upper elastic packing formed with a suction longitudinal hole is installed in a groove or a projection formed at a lower surface of the metallic upper frame which can be moved up or down, and the upper glass mask dry plate is closely contacted to and supported at the lower surface of the upper elastic packing in a horizontal direction by vacuum in the said suction longitudinal hole.

8. A mask holder device in the exposure device according to Claim 7 characterized in that the upper elastic packing is a plate-like packing made of magnetic rubber or resin.

9. A mask holder device in a bilateral exposure device in which a photo-mask is closely contacted with each of both surfaces of a substrate or a thin film formed with a resist and a light beam is radiated from above and below to expose the films characterized in that an upper elastic packing formed with a suction longitudinal hole is installed in a groove or a projection formed at the lower surface of the metallic frame which can be moved up or down, the upper glass mask dry plate is closely contacted to and supported at the lower surface of the upper elastic packing with vacuum in said suction longitudinal hole and in its turn the lower elastic packing formed with a suction longitudinal hole is installed in a groove or a projection formed on the upper surface of the metallic lower frame, the lower glass mask dry plate formed of transparent material is mounted in a horizontal direction on the upper surface of the lower elastic packing, and a peripheral edge of the lower surface of the lower glass mask dry plate is closely contacted by vacuum in the suction longitudinal hole formed in the said lower elastic packing.

10. A mask holder device in a bilateral exposure device according to Claim 9 characterized in that the upper elastic packing and the lower elastic packing are plate-like packings made of magnetic rubber or resin.
